(19) **Europäisches Patentamt**

**European Patent Office**

**Office européen des brevets**

(11) **EP 1 564 663 A1**

(12) # EUROPEAN PATENT APPLICATION

(43) Date of publication:
**17.08.2005 Bulletin 2005/33**

(51) Int Cl.7: **G06F 17/50**

(21) Application number: **04290350.0**

(22) Date of filing: **09.02.2004**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **ALCATEL
75008 Paris (FR)**

(72) Inventors:
• **Gerhardt, Erwin
71254 Ditzingen (DE)**
• **Graudszus, Werner
70469 Stuttgart (DE)**

(74) Representative: **Rausch, Gabriele, Dr. et al
Alcatel
Intellectual Property Department,
70430 Stuttgart (DE)**

(54) **Simulation method for a bipolar transistor**

(57)   A method is described for simulating the electrical characteristics of a bipolar transistor by means of a physical model, wherein the transistor is arbitrarily scaleable through arbitrary dimensioning ($W_E, L_E$) of the emitter, and wherein other dimensions, parameters and physical characteristics of the transistor are determined by means of the emitter's dimensions ($W_E, L_E$).

*Fig. 1*

**Description**

Technical field:

The invention relates to a method for simulating the electrical characteristics of a bipolar transistor by means of a physical model, wherein the transistor is arbitrarily scaleable through arbitrary dimensioning of the emitter, and wherein other parameters and physical characteristics of the transistor are determined by means of the emitter's dimensions, plus

a method for operating an electronic data processing apparatus for simulating the electrical characteristics of a bipolar transistor by means of a physical model, wherein the display device of the data processing apparatus at least temporarily is a mask with a format that requests the user to input arbitrary dimensions of the emitter of the bipolar transistor over the input device of the data processing apparatus, so that the transistor is arbitrarily scaleable through the dimensions of the emitter, wherein other parameters and physical characteristics of the transistor are determined by means of the selected dimensions of the emitter,

a computer program product with sequences of code statements for being used in connection with an electronic data processing apparatus for executing the method in order to operate an electronic data processing apparatus for simulating the electrical characteristics of a bipolar transistor, and

a computer program product with sequences of code statements stored on a data medium that can be read by an electronic data processing apparatus for executing the method for operating an electronic data processing apparatus for simulating the electrical characteristics of a bipolar transistor, in case the program product is executed on a data processing apparatus.

Background of the invention:

The invention relates to a method for simulating the electrical characteristics of a bipolar transistor by means of a physical model according to the specifying features of Claim 1 plus a method for operating an electronic data processing apparatus for simulating the electrical characteristics of a bipolar transistor according to the specifying features Claim 4.

When designing integrated circuits (ICs), developers want to benefit from the possibility to simulate the characteristics of the ICs beforehand. An IC consists primarily of a multitude of transistors that are integrated directly in the bipolar waver from which the IC is made. Because of their speed capabilities, integrated bipolar transistors are preferred active components for being used in ICs. In the course of the design phase and the technical development phase of ICs equipped with such transistors, what poses a main problem is the fact that both adequate physical models for the high-frequency components, especially the transistors, and the interrelation play between the electrical characteristics, such as amplification, bandwidth, film resistors, capacity per unit of area etc. are missing. Above all, tools are missing that allow a predictive modeling of high-frequency circuits making possible a parallel development of technology and circuits ('concurrent engineering'). Predictive here refers to the capability of predicting the electrical characteristics on the basis of technical data, such as design rules, doping profiles film resistors etc. clearly prior to the qualification of a semiconductor process for the production.

Earlier commonly used transistor models are not adequate any more to describe the performance of modern bipolar transistors. Today's high performance bipolar transistors require new advanced simulation models offering freedom to designers by means of a geometrically scaleable simulation method.

Technical purpose of the invention:

The technical purpose of the invention is to develop a method for simulating the electrical characteristics of an arbitrarily scaleable bipolar transistor and to develop a method for operating an electronic data processing apparatus for simulating the electrical characteristics of an arbitrarily scaleable bipolar transistor.

Disclosure of the invention and its advantages:

The invention's technical purpose is fully met by said method according to Claim 1 and said method according to Claim 3.

The proposed method for simulating the electrical characteristics of a bipolar transistor by means of a physical model with the specifying features of Claim 1 has the advantage over the state of the art that the transistor is arbitrarily scaleable by means of arbitrary dimensioning of the emitter, wherein other dimensions, like for example base and collector dimensions, parameters and physical characteristics, for example currents, resistors and capacitances of the transistor are determined by means of the emitter's dimensions by interrelating specific sizes like resistors for example to geometrical dimensions like areas, perimeters or lengths and widths for example.

Previously known simulation programs for bipolar transistors predefine discrete values for the transistors' dimensions without offering the user of such a program the possibility to work with intermediate values. Moreover, with known simulation programs the values for the electrical characteristics of transistors with different and solely discretely selectable dimensions are linearly interpolated between the values of a limited number of experimentally evaluated transistors, although these characteristics depend on a multitude of parameters of which not all change linearly with the changing transistor dimensions. As opposed to that, the proposed method allows the simulation of the electrical characteristics of a bipolar transistor with arbitrary dimensions that can be arbitrarily chosen during the ICs' design phase, with the emitter's dimensions primarily influencing the outer and also the other dimensions of a bipolar transistor and with every physical parameter determining the electrical characteristics being derived from the emitter's dimensions.

The core of the invention is to interrelate the physical characteristics and also appropriate parameters of a bipolar transistor to the geometrical dimensions determined by the emitter dimensions, particularly the length and the width of the emitter.

A preferred embodiment of the proposed method for simulating the electrical characteristics of a bipolar transistor by means of a physical model is characterized by the steps of

- correction of the transistor's emitter dimensions with a spacer width value that describes the encroachment caused by the spacer before calculating an effective electric emitter dimension, wherein the other sizes and areas are derived from the corrected emitter dimensions,
- determination of a base current by dividing into area and perimeter specific parts,
- scaling of an extrinsic base resistance as a function of the emitter length,
- scaling of an emitter resistance as a function of the emitter area, and
- determination of a base-emitter capacitance from an intrinsic area, an extrinsic parameter and an oxide-like third part.

A preferred embodiment of the proposed method for simulating the electrical characteristics of a bipolar transistor by means of a physical model is characterized by the correction of all geometrical dimensions by correction factors, wherein geometrical dimensions are areas, perimeters, lengths and widths for example.

The proposed method for operating an electronic data processing apparatus for simulating the electrical characteristics of a bipolar transistor by means of a physical model with the specifying features of Claim 3 has the advantage over the state of the art that the display device of the data processing apparatus at least temporarily is a mask with a format that requests the user to input arbitrary dimensions of the emitter of the bipolar transistor over the input device of the data processing apparatus, so that the transistor is arbitrarily scaleable through the dimensions of the emitter, wherein other parameters and physical characteristics of the transistor are determined by means of the selected dimensions of the emitter.

Another preferred embodiment of the proposed method for operating an electronic data processing apparatus for simulating the electrical characteristics of a bipolar transistor by means of a physical model is characterized by the steps of

- correction of the transistor's emitter dimensions with a spacer width value that describes the encroachment caused by the spacer before calculating an effective electric emitter size, wherein the other sizes and areas are derived from the corrected emitter dimensions,
- determination of a base current by dividing into area and perimeter specific parts,
- scaling of an extrinsic base resistance as a function of the emitter length,
- scaling of an emitter resistance as a function of the emitter area, and
- determination of a base-emitter capacitance from an intrinsic area, an extrinsic parameter and an oxide-like third part.

A preferred embodiment of the invention is a computer program product with sequences of code statements for being used in connection with an electronic data processing apparatus for executing the proposed method in order to operate an electronic data processing apparatus for simulating the electrical characteristics of a bipolar transistor by means of a physical model.

A particularly preferred embodiment of the invention is a computer program product with sequences of code statements stored on a data medium that can be read by an electronic data processing apparatus for executing the proposed method for operating an electronic data processing apparatus for simulating the electrical characteristics of a bipolar transistor by means of a physical model, in case the program product is executed on a data processing apparatus.

The drawing shows the schematic structure of a bipolar transistor from the top view and in a cross-section perpendicular to the top view.

Paths for performing the invention:

In the following, the basics of a geometrically scaleable method to be used with different commercial simulators are described including a short description of the parameters to be considered.

The first step starts with the input of the length LE and width WE of the emitter. In a second step, all other geometrical dimensions are determined by the emitter dimensions LE and WE. In a third step, all dimensions are corrected for receiving the real dimensions of the transistor. The fourth step is the determination of the specific dimensions like resistances, capacitances and currents, wherein in the fifth step the physical characteristics were determined by interrelating the specific dimensions with the geometrical dimensions.

Geometry scaling

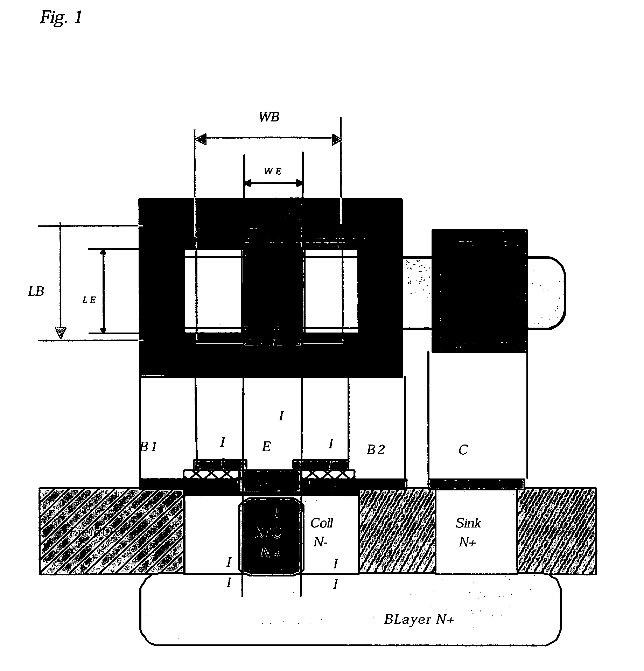

The first step of any physics-based geometry scaling is the analysis of the process to be scaled. The sketch in Figure 1 shows the main features and areas of a transistor to be taken into account.

From the bottom to the top: the N+ buried layer shielding the device from the P-substrate. To the right the N+ sinker region to make ohmic/low resistivity contact between buried layer and collector poly/metal. At the left side, above the buried layer and within the low(er) doped epi-collector, the additional selectively implanted -intrinsic-collector having a high doping concentration. The device is isolated by a shallow trench or Locos oxide isolation.

The thin SiGe base layer is grown in form of an intrinsic monosilicon and an extrinsic polysilicon layer which can additionally be higher doped.

The core base-emitter stack is, as it is usually applied, a double-poly inside spacer complex. Important for the modelling is the fact that between emitter and base nodes a constant, MOS-like, oxide capacitance exists. Due to the additional doping the external poly-base is low ohmic while the intrinsic part is relative high ohmic and operating point dependent.

For this example no process tolerances were taken into account. However, besides the effects resulting from the processing like, e.g., the out-diffusion of the buried layer some of the layout sizes are quite different from the drawn ones.

Most important, the emitter layout size has first to be corrected by a spacer width value before calculating effective electrical emitter sizes. This intrinsic area is marked by I in Figure 1. It is used for partitioning into intrinsic and extrinsic transistor parts, to area- and perimeter specific currents and capacitances as well as for the calculation of the intrinsic part of the base resistor. Starting with the layout sizes, transistor geometries will be calculated by using the length LE and the width WE of the emitter, e.g. WE=0.8µm and LE=9.7 µm, shown in Figure 1. The emitter forms the basic area of the transistor, so most of the other sizes and areas can be derived from it.

WE and LE of the emitter are corrected by an emitter length correction factor DLE and an emitter width correction factor DWE considering the encroachment given by the spacer and a correction factor due to lateral emission of the electrons (GAMMAC) considering the electrical widening due to the partly laterally emitted electrons.

The size of the base area determined by the width WB and the length LB of the base is not modified, while the collector, i.e. buried layer size is corrected by a collector width correction factor DWC and a collector length correction factor DLC due to the out-diffusion. All relevant area and perimeter sizes are calculated from the data above.

Current parameters

Two methods to extract the core parameters, the saturation current coefficient C10 and the zero-bias hole charge Qpo exist: first by using the transfer characteristic IC(Vbe) and second, by the usage of specific tetrode structures. Using method 1, the condition of $V_{BC}$=0 V and setting the ideality factor MCF=1 the general equation for IC can be reduced for small currents (equation (1)). Thus C10/$Q_{PT}$ can be extracted by simultaneously optimising the collector current curve fit inside the valid current range. Of course, first Qjei has to be calculated from earlier determined capacitances.

$$\left(\frac{C10}{Qpt}\right) = \frac{I_{Cmeas}}{\exp\left(\frac{Vbe}{Vt}\right)} \quad (1)$$

with Qpt=Qpo+Qjei

One drawback of this method is the strong dependency on the correct temperature value used (dependency on $U_T$). Even very small differences and uncertainties will result in large deviations of extracted C10 and Qpo results affecting extracted parameters and thus the fit quality of later steps.

The second, more advantageous method reuses the tetrode measurements, already done to extract the intrinsic base (sheet-) resistance. This method bases on the fact that the change of the operating point results in a change of injected charges in the base region and hence change of base resistance. The ratio of base resistance at a specific Vbe voltage to the zero Volt value then equals the ratio of the sum of injected charges to the Qpo charge (equation (2)). First, the charges at the different OP used for extraction are calculated, while the resistance ratio is known from the previous extraction.

$$\frac{RSBio}{RSBi} - 1 = \frac{\Sigma Q_{JXi}}{Q_{PO}} \quad (2)$$

The value of parameter $C_{10}$ will then be directly calculated from equation (1). Though in most cases not necessary, because close to one, finally parameter MCF could be optimised iteratively.

The basic model parameters C10 and QP0 are related to the intrinsic base-emitter area of the device, in a way that their ratio shows the same dependency on the layout emitter area AreaE as the saturation current itself. So the ideality factor MCF is set to a common value of 1,008.

A self-heating effect is modelled with a thermal resistance parameter RTH. Thermal resistance RTH scales in a physically meaningful manner with the size of the collector area AreaC.

Forward base current is divided into area and perimeter specific parts using effective values effective emitter area AreaEeff, effective emitter perimeter PeriEeff. The reverse base-collector current is partitioned using AreaEeff for the intrinsic part and (AreaB-AreaEeff), i.e., the extrinsic base-collector area for the extrinsic part. Base recombination currents can be estimated on basis of our measured devices. The scaling can be done as a function of AreaE.

Resistor Parameters

The extraction of a correct resistance value is a prerequisite for an exact transistor model. The base resistance RB determines e.g. the DC and noise and switching characteristics as well as the maximum power gain transit frequency of a bipolar transistor. RB strongly depends on the operation point, mainly on the current flowing. Due to the lateral flow, emitter current crowding leads to a decrease of the value, the modulation of the respective junctions results in an increase of RB, while conductance modulation and Kirk effect lead to a decrease again.
Different methods to extract the base resistance exist, e.g. from Z-parameters; or the "modified circle impedance" method using an extended equivalent circuit by taking into account extrinsic collector-base capacitance CCB and extrinsic collector resistance RCX elements. The extrapolation of Re(h11) vs. Im(h11) for high frequencies results in RB+RE, wherein RE is the emitter resistance. Taking the extracted values for a sufficient operation point (OP) range and subtracting the constant, already extracted RE, the resulting base resistance curve leads to parameters for the intrinsic base resistance RBI and the extrinsic base resistance RBX.
Another very useful physics based method is to use the tetrode structures for base resistance extraction. It allows to extract the intrinsic base sheet resistance RSBI as a function of the current flowing in normal forward condition. By using different tetrodes (with different emitter width WE) the intrinsic base sheet resistance RSBI can be extracted from the slope of RB vs. WE and RBX from the y intercept of the same curve, respectively.
Extrinsic base resistance data is extracted from direct current characteristics DC. The scaling is done as a function of emitter length (LE+WE).
Intrinsic base resistance values are calculated as a function of intrinsic base sheet resistance and WE/LE data of the transistors basing on Gosh's formula. The values result in a reasonable intrinsic to extrinsic base ratio of about 4.
As the emitter resistance consists mainly of a contact resistance at the poly-mono-silicon surface, the emitter resistance can be scaled as a function of emitter area AreaE.

Collector resistance scaling

As in case of other parameters, too, no appropriate measurement structures exist for the collector resistance scaling and measurement is not optimum to extract exact values, those extracted values are used together with physical meaningful scaling for optimisation.

Intrinsic collector

As the epi thickness of the collector region is a given process dependent constant value this parameter depends on the width of the area where the collector current flows, i.e., on effective emitter area AreaEeff.

Extrinsic Collector

Since the extrinsic collector consists mainly of the buried layer and a connecting sinker part, this value can be scaled as a function of LE.

Substrate Resistor

The substrate resistor can not be calculated exactly - it is a complicated 3D problem and depends on a real circuit on the layout and its given distances itself. For the structures to be modelled it can be assumed a substrate ring surrounding the device thus to be a function of the buried layer perimeter PeriC.

Base-Emitter Capacitance

The base-emitter capacitance consists of three parts: an intrinsic area, an extrinsic perimeter and an oxide-like third part. The best fit could be achieved by scaling the intrinsic part as a function of AreaE, the extrinsic one by the perimeter PeriE and the oxide as a function of perimeter PeriE plus a constant value of 5fF. The latter one could possibly be attributed to some corner effects of the spacer oxide region.

Base-Collector Capacitance

Base-collector capacitance is divided into two parts: an intrinsic and an extrinsic part. They correspond to the two respective transistor areas "I" and "II" in Figure

1. It is partitioned using the effective intrinsic part AreaEeff and the corresponding extrinsic one (AreaB-AreaEeff).
A dependency mostly on the perimeter of the buried layer exists, so the collector-substrate capacitance is scaled as a function of the buried layer perimeter PeriC.

Substrate Capacitance

The substrate capacitance can not be calculated exactly as it is like the substrate resistor a complicated 3D problem. It is scaled as a function of the buried layer area AreaC.

Transit time related parameters

The basic transit time related parameters do not depend on geometry. Of course, the intrinsic collector resistance, affecting the onset of the critical current ICK depends on geometry size and is scaled. However, a small dependency of the transit frequency on emitter dimensions exists. A change in emitter dimension influences the transit time primarily through a modification of internal to peripheral partitioning components. The geometry-dependent transit time is described by a modification of the intrinsic transit time by the ratio of real emitter area to effective emitter area, i.e. AreaEeff/AreaE for the internal and (1-AreaEeff/AreaE) for the peripheral part, respectively.

Commercial applicability:

The invention is commercially applicable particularly in the field of pre-development and development of ICs on the basis of submicron bipolar and BiCMOS technology.

**Claims**

1. Method for simulating the electrical characteristics of a bipolar transistor by means of a physical model, **characterized in that** the transistor is arbitrarily scaleable through arbitrary dimensioning ($W_E$, $L_E$) of the emitter, wherein other dimensions, parameters and physical characteristics of the transistor are determined by means of the emitter's dimensions ($W_E$, $L_E$).

2. Method according to Claim 1, **characterized by** the steps of

   - correction of the emitter layout size of the transistor with a spacer width value that describes the encroachment caused by the spacer before calculating an effective electric emitter size, wherein the other sizes and areas are derived from the corrected layout size,
   - determination of a base current by dividing into area and perimeter specific parts,
   - scaling of an extrinsic base resistance as a function of the emitter length,
   - scaling of an emitter resistance as a function of the emitter area, and
   - determination of a base-emitter capacitance from an intrinsic area, an extrinsic parameter and an oxide-like third part.

3. Method according to Claim 1 or 2, **characterized by** correction of all geometrical dimensions.

4. Method for operating an electronic data processing apparatus for simulating the electrical characteristics of a bipolar transistor by means of a physical model, **characterized in that** the display device of the data processing apparatus at least temporarily is a mask with a format that requests the user to input arbitrary dimensions ($W_E$, $L_E$) of the emitter of the bipolar transistor over the input device of the data processing apparatus, so that the transistor is arbitrarily scaleable through the dimensions ($W_E$, $L_E$) of the emitter, wherein other parameters and physical characteristics of the transistor are determined by means of the selected dimensions ($W_E$, $L_E$) of the emitter.

5. Method according to Claim 4, **characterized by** the steps of

   - correction of the transistor's emitter dimensions with a spacer width value that describes the encroachment caused by the spacer before calculating an effective electric emitter size, wherein the other sizes and areas are derived from the corrected emitter dimensions,
   - determination of a base current by dividing into area and perimeter specific parts,
   - scaling of an extrinsic base resistance as a function of the emitter length,
   - scaling of an emitter resistance as a function of the emitter area, and
   - determination of a base-emitter capacitance from an intrinsic area, an extrinsic parameter and an oxide-like third part.

6. Computer program product with sequences of code statements for being used in connection with an electronic data processing apparatus for executing the method according to Claims 3 or 4.

7. Computer program product with sequences of code statements stored on a data medium that can be read by an electronic data processing apparatus for executing the method according to Claims 3 or 4, in case the program product is executed on a data processing apparatus.

Fig. 1

**European Patent Office**

# EUROPEAN SEARCH REPORT

Application Number

EP 04 29 0350

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | YUAN J S ET AL: "A scalable bipolar transistor model for circuit simulation" PHYSICA STATUS SOLIDI A AKADEMIE VERLAG GERMANY, vol. 168, no. 1, 16 July 1998 (1998-07-16), pages 209-222, XP009037200 ISSN: 0031-8965 in particular section '2.3 Scalable BJT parameters' * the whole document * ----- | 1-7 | G06F17/50 |
| X | SCHROETER M ET AL: "PHYSICAL MODELING OF LATERAL SCALING IN BIPOLAR TRANSISTORS" IEEE JOURNAL OF SOLID-STATE CIRCUITS, IEEE INC. NEW YORK, US, vol. 31, no. 10, 1 October 1996 (1996-10-01), pages 1484-1492, XP000638098 ISSN: 0018-9200 in particular section 'II. Theory' * the whole document * ----- | 1-7 | |
| X | WALKEY D J ET AL: "Predictive modelling of lateral scaling in bipolar transistors" 2 October 1995 (1995-10-02), BIPOLAR/BICMOS CIRCUITS AND TECHNOLOGY MEETING, 1995., PROCEEDINGS OF THE 1995 MINNEAPOLIS, MN, USA 2-3 OCT. 1995, NEW YORK, NY, USA,IEEE, US, PAGE(S) 74-77 , XP010159321 ISBN: 0-7803-2778-0 * the whole document * ----- -/-- | 1-7 | |

**TECHNICAL FIELDS SEARCHED (Int.Cl.7)**

G06F

The present search report has been drawn up for all claims

| Place of search | Date of completion of the search | Examiner |
|---|---|---|
| Munich | 30 September 2004 | Lerbinger, K |

EPO FORM 1503 03.82 (P04C01)

**European Patent Office**

## EUROPEAN SEARCH REPORT

Application Number

EP 04 29 0350

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | "SIMULATION & MODELING VBIC95: AN IMPROVED BIPOLAR TRANSISTOR MODEL" IEEE CIRCUITS AND DEVICES MAGAZINE, IEEE INC. NEW YORK, US, vol. 12, no. 2, 1 March 1996 (1996-03-01), pages 11-15, XP000589126 ISSN: 8755-3996 * the whole document *  ----- | 1-7 | |

**TECHNICAL FIELDS SEARCHED (Int.Cl.7)**

The present search report has been drawn up for all claims

| Place of search | Date of completion of the search | Examiner |
|---|---|---|
| Munich | 30 September 2004 | Lerbinger, K |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)